# EUROPÄISCHE PATENTSCHRIFT

(11) **EP 1 554 752 B1**
(45) Veröffentlichungstag und Bekanntmachung des Hinweises auf die Patenterteilung: **18.11.2009**
(21) Anmeldenummer: 03808690.6
(22) Anmeldetag: 06.09.2003
(51) Int. Cl.: H01L 23/367, H01L 25/07, H01L 23/42, H01L 21/48

(54) **VORRICHTUNG UMFASSEND EIN HALBLEITERMODUL UND EINEN KÜHLKÖRPER**
DEVICE INCLUDING A SEMICONDUCTOR MODULE AND A HEATSINK
DISPOSITIF COMPORTANT UNE MODULE SEMI-CONDUCTEUR ET UN DISSIPATEUR

(30) Priorität: 16.10.2002 DE 10248369; 05.11.2002 DE 10251411
(43) Veröffentlichungstag der Anmeldung: 20.07.2005
(73) Patentinhaber: SEW-Eurodrive GmbH & Co, D-76646 Bruchsal (DE)
(72) Erfinder: HÖRNLE, Klaus, 75038 Oberderdingen (DE)
(86) Internationale Anmeldenummer: PCT/EP2003/009909
(87) Internationale Veröffentlichungsnummer: WO 2004/036643

(56) Entgegenhaltungen:
- EP-A- 0 401 147
- EP-A- 0 883 192
- US-A- 4 823 863
- US-A- 5 098 609
- US-A- 5 825 087
- US-B1- 6 250 127
- US-B1- 6 275 381

## Beschreibung

Die Erfindung betrifft eine Vorrichtung.

Bei Umrichtern ist bekannt, dass ein Halbleitermodul, das ein oder mehrere Leistungshalbleiter-Bauelemente umfasst, mit einem Kühlkörper verbunden ist. Dabei sind die Kontaktflächen derart bearbeitet, dass diese Flächen möglichst eben und glatt sind und sich möglichst genau aneinander anschmiegen. Bei der Montage wird Wärmeleitpaste auf die Kontaktflächen aufgebracht und danach Halbleitermodul und Kühlkörper zusammengefügt.

Halbleitermodul und Kühlkörper werden mit Befestigungsschrauben verbunden.

Wenn über die gesamte Standzeit der Wärmewiderstand zwischen Halbleitermodul und Kühlkörper nicht konstant bleibt, ist eine Dimensionierung des Umrichters nicht genau möglich, da er in diesem Fall anfangs Elektromotoren mit einer höheren Leistung versorgen könnte als gegen Ende der Standzeit. Im genannten Fall sind die Nennleistungsdaten des Umrichters auf den schlechteren Fall, also den Wärmeübergangswiderstand am Ende der Standzeit auszurichten.

Das Verschlechtern des Wärmeübergangswiderstandes kann nämlich zu einem Geräteausfall führen, weil die Wärme der Leistungshalbleiter nicht mehr in ausreichender Menge abführbar ist und daher die Temperatur der Leistungshalbleiter erhöht ist, wodurch die Zerstörung des Halbleitermoduls eintreten kann. Insbesondere kann es auch vorkommen, dass die Verschlechterung des Wärmewiderstandes im Kontaktbereich zum Kühlkörper nicht gleichmässig verteilt ist. Daher kann eine Zerstörung des Halbleitermoduls eintreten, obwohl ein Temperaturfühler im Halbleitermodul eingebaut ist, der die Temperatur überwacht und bei Überhitzung ein Abschalten des Geräts oder eine Reduzierung der Leistung des Geräts auslösen kann. Dieser Temperaturfühler ist nämlich fertigungsbedingt stets in einem Abstand zu den verlustleistungserzeugenden Halbleiterbauelementen angeordnet, so dass er bei verschlechterter Wärmeableitung eine andere Temperatur als die Temperatur der Leistungshalbleiter des Halbleitermoduls misst, insbesondere eine niedrigere.

Die Lebensdauer solcher Umrichter ist also wesentlich mitbestimmt durch die Anzahl und Größe der Temperaturhübe.

Der Erfindung liegt daher die Aufgabe zugrunde, einen Vorrichtung, umfassend Halbleitermodul und Kühlkörper, derart weiterzubilden, dass die Wärmeabfuhr über die gesamte Standzeit möglichst gut bleibt.

Eine Vorrichtung nach dem ersten Teil des Anspruchs 1 ist aus US-A-5 825 087 bekannt. US-B-6 275 381 und US-B-6 250 127 offenbaren weitere gekühlte Vorrichtungen.

Erfindungsgemäß wird die Aufgabe bei die Vorrichtung nach den im kennzeichnenden Teil des Anspruchs 1 angegebenen Merkmalen gelöst.

Wesentliche Merkmale der Erfindung bei der Vorrichtung sind, dass die Vorrichtung eine elektronische Schaltung mit mindestens einem Halbleitermodul umfasst, wobei das Halbleitermodul mit dem Kühlkörper wärmeleitend verbunden ist zur Abführung der Wärme vom Halbleitermodul über den Kühlkörper an ein weiteres Medium oder an eine weitere Vorrichtung, wobei zwischen den Kontaktflächen des Halbleitermoduls und des Kühlkörpers Wärmeleitpaste zur Verbesserung der Wärmeleitung, insbesondere Verringerung des Wärmeübergangswiderstandes, eingebracht ist, wobei die Kontaktfläche des Halbleitermoduls oder die Kontaktfläche des Kühlkörpers aufgeraut bearbeitet und/oder ausgeführt ist. Von Vorteil ist dabei, dass die Wärmeabfuhr über die gesamte Standzeit möglichst gut bleibt. Insbesondere erfahren große feste Bestandteile der Wärmeleitpaste eine Fixierung, wodurch die Auswaschung der Wärmeleitpaste verhindert oder zumindest stark reduziert wird. Außerdem ist die Nennleistung der Vorrichtung, erhöhbar und die Vorrichtung ist auch bei Anwendungen einsetzbar, die eine hohe Temperaturwechselbelastung, insbesondere für das Halbleitermodul und/oder den Kühlkörper, erfordern.

Die Lebensdauer oder zumindest die von dem Halbleitermodul ausgehende Beeinflussung der Lebensdauer der Vorrichtung ist also hoch, auch wenn sehr viele und sehr starke Temperaturhübe erfolgen, insbesondere ist die Lebensdauer höher als bei Vorrichtungen nach Stand der Technik mit nicht aufgerauhter Kontaktfläche.

Bei einer vorteilhaften Ausgestaltung sind zur wärmeleitenden Verbindung zwischen Halbleitermodul und Kühlkörper die Kontaktflächen eben bearbeitet, damit die Kontaktflächen dicht aneinander anliegen. Von Vorteil ist dabei, dass der Wärmeübergangswiderstand von Halbleitermodul und Kühlkörper gering ist.

Bei einer vorteilhaften Ausgestaltung weisen die Kontaktflächen eine Ebenheit, also Formabweichung oder Gestaltsabweichung erster Ordnung, auf, die besser ist als 5 µm pro 10 mm. Besonders vorteilig ist dabei ein Wert von 2 µm oder weniger. Von Vorteil ist dabei, dass wiederum der Wärmeübergangswiderstand von Halbleitermodul und Kühlkörper gering ist.

Bei einer vorteilhaften Ausgestaltung ist die Rauheit größer als die Korngröße der festen Bestandteile der Wärmeleitpaste. Von Vorteil ist dabei, dass die festen Bestandteile eine Fixierung erfahren, wenn Halbleitermodul und Kühlkörper verbunden werden, insbesondere lösbar mit Befestigungsschrauben.

Bei einer vorteilhaften Ausgestaltung ist die Rauheit größer als die um 10 µm verminderte Korngröße der festen Bestandteile der Wärmeleitpaste. Von Vorteil ist dabei, dass eine besonders gute Fixierung der festen Bestandteile zwischen den Profilkuppen und/oder Profiltälern den Kontaktflächen des Halbleitermoduls und des Kühlkörpers erreichbar ist.

Bei einer vorteilhaften Ausgestaltung ist die Rauheit mit der gemittelten Rauhtiefe R_{z} gemäß DIN 4768 beschrieben und/oder dass die gemittelten Rauhtiefe R_{z} gemäß DIN 4768 einen Wert hat, der größer ist als 20 und/oder die gemittelten Rauhtiefe R_{z} gemäß DIN 4768 beträgt 25. Von Vorteil ist dabei, dass eine handelsübliche Wärmeleitpaste verwendbar ist und die Rauheit der Kontaktoberfläche kostengünstig mit bekannten Mitteln herstellbar ist.

Bei einer vorteilhaften Ausgestaltung sind die Kontaktflächen mittels Fräsen, Hohnen, Schleifen und/oder Läppen zur Herstellung der Ebenheit, also ebenen Form, bearbeitet. Von Vorteil ist dabei, dass die ebene Form in kostengünstiger Art und Weise erreichbar ist.

Bei einer vorteilhaften Ausgestaltung sind die Kontaktflächen mittels Sandstrahlen, Erodieren oder Ätzen zur Herstellung der Rauheit bearbeitet. Von Vorteil ist dabei, dass die Rauheit in kostengünstiger Weise erreichbar ist und die Vertiefungen oder Profiltäler in der Kontaktoberfläche keine Vorzugsrichtung aufweisen.

Bei einer vorteilhaften Ausgestaltung umfasst das Halbleitermodul ein oder mehrere Leistungshalbleiter-Bauelemente. Von Vorteil ist dabei, dass als Vorrichtung ein Umrichter mit einer Leistungs-Endstufe verwendbar ist und hierfür ein industrieübliches Teil einsetzbar ist.

Bei einer vorteilhaften Ausgestaltung ist die Vorrichtung ein Umrichter zur elektrischen Versorgung eines oder mehrerer Elektromotoren, insbesondere linearer oder rotatorischer Elektromotoren. Bei einer vorteilhaften Ausgestaltung ist das Halbleitermodul mit dem Kühlkörper derart wärmeleitend verbunden, dass der Wärmeübergangswiderstand zwischen Kühlkörper und Halbleitermodul kleiner ist als der Wärmeübergangswiderstand zwischen Halbleitermodul und weiteren Vorrichtungen oder Medien. Insbesondere ist das Medium Umgebungsluft, ein metallisches Gehäuse oder eine Flüssigkeit. Von Vorteil ist dabei, dass der Umrichter in verschiedenen Anwendungen einsetzbar und in verschiedenen Ausführungsformen ausführbar ist.

Weitere Vorteile ergeben sich aus den Unteransprüchen.

### Bezugszeichenliste

- 1: Kühlkörper
- 2: Halbleitermodul
- 3: Kontaktfläche des Kühlkörpers
- 4: Wärmeleitpaste
- 5: Kontaktfläche vom Halbleitermodul
- 6: Befestigungsschrauben

### Die Erfindung wird nun anhand von Abbildungen näher erläutert:

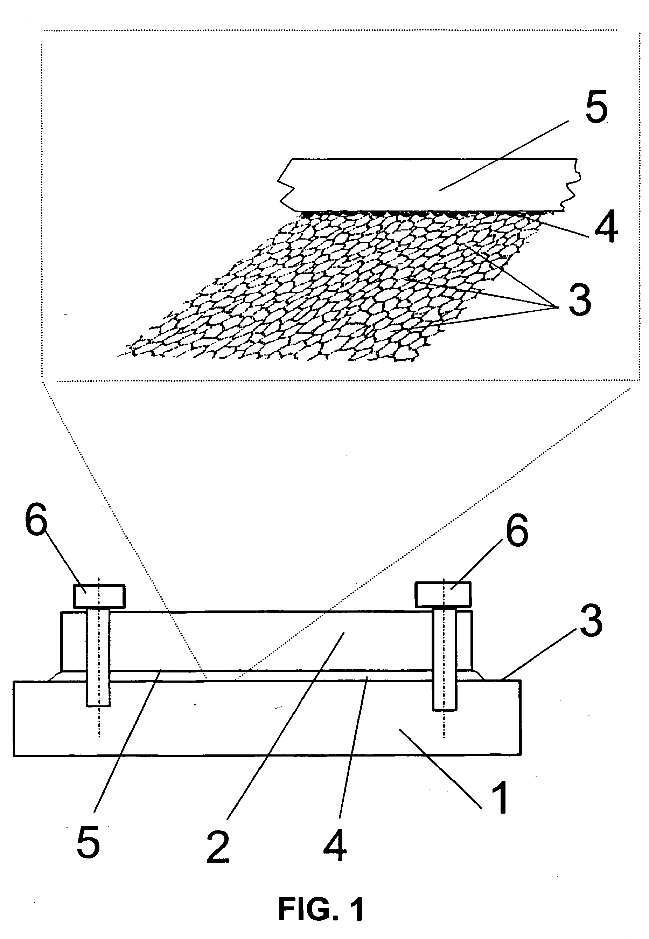

Im unteren Teil der Figur 1 ist ein Ausschnitt einer erfindungsgemäßen Vorrichtung in Schnittansicht schematisch skizziert, wobei im oberen Teil ein vergrößerter Ausschnitt gezeigt ist.

Das Halbleitermodul 2 ist mittels der Befestigungsschrauben 6, die als lösbare Verbindung eingesetzt sind, mit dem Kühlkörper 1 verbunden. Zwischen die Kontaktfläche 3 des Kühlkörpers 1 und die Kontaktfläche 5 vom Halbleitermodul 2 ist Wärmeleitpaste 4 eingebracht.

Zur Herstellung eines guten Wärmeübergangs sind die Kontaktflächen derart bearbeitet, dass sie möglichst parallel sind, also eine zueinander passende Form aufweisen.

Hierfür ist die Kontaktfläche 3 des Kühlkörpers überfräst, also mittels Fräsen bearbeitet. Bei weiteren erfindungsgemäßen Ausführungsbeispielen sind auch Bearbeitungen durch Hohnen, Schleifen und/oder Läppen zur Herstellung der Ebenheit, also ebenen Form, verwendbar. Diese können auch mit einem Fräsvorgang sich abwechseln.

Bei diesen Bearbeitungsvorgängen, insbesondere beim Fräsen, entstehen Rillen oder entsprechende Vertiefungsausformungen im mikroskopischen Bereich, die eine Vorzugsrichtung aufweisen.

Das Überfräsen bewirkt erstens, dass die erforderliche Ebenheit der Kontaktfläche erreichbar ist, damit das Halbleiternmodul und der Kühlkörper eine möglichst große Auflagefläche haben.

Weiter bewirkt das Überfräsen, dass bei den Halbleitermodulen, wenn diese mit einem dünnen Keramikboden ausgeführt sind, der die Kontaktfläche des Halbleiterbausteins bildet, die Leistungshalbleiter auf den Kühlkörper gedrückt werden mit einer möglichst gleichmäßigen Spannungsverteilung. Eine unebene Auflagefläche kann nämlich zum Brechen des Bodens führen.

Das Überfräsen bewirkt zusätzlich, dass die Gusshaut der rohen Oberfläche beim Überfräsen entfernt wird. Eine solche Gusshaut, von beispielsweise Kühlkörpern aus Aluminiumdruckguss, weist nämlich einen höheren Wärmeübergangswiderstand auf. Somit sorgt das Überfräsen für eine zusätzliche Verbesserung der Wärmeableitung.

Wie erwähnt, wird zur weiteren Verbesserung des Wärmeüberganges zwischen den Halbleiterboden und der Kontaktfläche auf dem Kühlkörper Wärmeleitpaste eingebracht. Diese Wärmeleitpaste füllt die verbleibenden Mikro-Zwischenräume, die zwischen dem Halbleiterboden und der Kühlkörperkontaktfläche sind, aus.

Die verwendete Wärmeleitpaste besteht aus festen Bestandteilen, insbesondere sehr gut wärmeleitenden Stoffen, wie beispielsweise Aluminiumoxid oder Silber, und einer Flüssigkeit, wie beispielsweise Siliconöl. Es sind bei anderen erfindungsgemäßen Ausführungsbeispielen auch weitere und/oder andere Stoffe verwendbar.

Bei gewissen Anlagen oder Maschinen sind wechselnde Belastungen oder Ruheintervalle gefordert. Dabei kann es dementsprechend zu Temperaturwechselbelastungen des Halbleitermoduls kommen. Die Temperatur steigt dabei um gewisse Beträge an, die als Temperaturhub bezeichnet werden. Die Häufigkeit der Temperaturhübe trägt auch zu einer Belastung des Halbleitermoduls und der Wärmeleitpaste bei.

Die Kontaktfläche des Halbleitermoduls weist eine Rauhigkeit von nur 1 bis 10 µm auf. Die Rauheit ist also sehr viel kleiner als die Korngröße der festen Bestandteile der Wärmeleitpaste.

Die Kontaktfläche des Kühlkörpers wird durch einen entsprechend zugehörigen Bearbeitungsschritt aufgerauht und weist dann eine Rauhigkeit in der Größenordnung der Korngröße der festen Bestandteile der Wärmeleitpaste auf. Als solcher Bearbeitungsschritt ist Sandstrahlen, Erodieren oder Ätzen verwendbar. Besonders einfach und kostengünstig ist Sandstrahlen. Bei diesem Bearbeitungsschritt zum Herstellen der Rauheit, wird die Form der Kontaktfläche, also die Ebenheit, nicht geändert. Jedoch werden Bearbeitungsrillen des Fräsvorgangs überstrahlt und sozusagen mit Trichtern, die infolge der Einschläge entstehen, versehen.

Da die Rauheit in der Größenordnung der Korngröße der festen Bestandteile der Wärmeleitpaste liegt, werden diese festen Bestandteile in den Mikro-Tiefen der Kontaktfläche fixiert. Die beste Wahl von Rauheit und Korngröße liegt dann vor, wenn die Kontaktflächen möglichst dicht aneinander anliegen und die Mikroräume mit den festen Bestandteilen möglichst gut aufgefüllt sind.

Wesentlich bei der Erfindung ist, dass die festen Bestandteile der Wärmeleitpaste mittels der Oberflächenstruktur im Mikro-Bereich eine Fixierung erfahren.

Eine Fixierung von möglichst allen festen Bestandteilen bei sich bewegender Wärmeleitpaste, insbesondere sich bewegendem Flüssigkeitsanteil, erfolgt dann sehr gut, wenn die festen Bestandteile in einer zugehörigen jeweiligen mikroskopischen Vertiefung sitzen.

Somit kommt es zu keiner Auswaschung der festen Bestandteile der Wärmeleitpaste bei wechselnder Temperaturbelastung. Abhängig vom Wärmeausdehnungskoeffizient der flüssigen Bestandteile dehnen sich diese bei Temperaturerhöhung aus. Also treten im Mikrobereich Strömungen auf, die von Temperaturänderungen verursacht werden. Bei Temperaturerhöhung sind diese Strömungen im Wesentlichen in Richtung des Außenbereichs gerichtet, also in Richtung der nicht durch die Kontaktflächen festgelegten Begrenzung des Wärmeleitpaste. Wenn die festen Bestandteile keine Fixierung erfahren würden, würden sie mit den flüssigen Bestandteilen zusammen in den Randbereich oder Außenbereich transportiert werden. Bei Zurückfallen der Temperatur ziehen sich die flüssigen Bestandteile zwar wieder in Richtung des Innenbereichs der Kontaktfläche zusammen, die festen Bestandteile würden aber nicht an denselben Ort zurücktransportiert werden sondern etwas weiter außen als anfangs bleiben. Auf diese Weise würden die festen Bestandteile nach häufig ausgeführten und wiederholten Temperaturwechseln sich im Außenbereich immer mehr ansammeln.

Dann wäre auch die Kühlung der Leistungshalbleiter des Halbleitermoduls nicht mehr ausreichend gewährleistbar.

Das beschriebene Auswaschen der Wärmeleitpaste würde durch die Rillen, die durch die fräsende Bearbeitung entstehen, begünstigt werden. Diese Rillen, die durch die spanende Bearbeitung entstanden sind, sind gleichartig verlaufend, insbesondere auch in den Randbereich oder Außenbereich laufend, und bilden Kanäle in denen sich die flüssigen Bestandteile bewegen und auch die festen Bestandteile, wenn genügend Raum hierfür vorhanden wäre.

Mittels der erfindungsgemäßen Aufrauhung, die durch Sandstrahlen hergestellt wird, erfahren die festen Bestandteile aber eine Fixierung, weil mikrospopische Vertiefungen geschaffen werden, die aber keine Vorzugsrichtung aufweisen, nicht miteinander verbunden sind und auch keine Kanäle darstellen. Insbesondere sind keine Rillen vorhanden, die die festen Bestandteile in Richtung Außenbereich transportieren könnten. Somit tritt das oben beschriebene Auswaschen nicht oder höchstens stark vermindert auf. Außerdem bewegt sich der flüssige Bestandteil der Wärmeleitpaste eher im Bereich der Oberflächenspitzen zwischen der Kontaktfläche des Kühlkörpers und der Kontaktfläche des Halbleitermoduls.

Infolge des Sandstrahlens ist die beim Fräsen entstandene Rillenstruktur nicht mehr vorhanden. Somit liegen die festen Bestandteile in abgeschlossenen Bereichen und nicht mehr in den Rillenkanälen, wo sie leichter transportierbar wären.

Bei Temperaturänderung entstehen auch mechanische Spannungen und Verformungen des Halbleitermoduls und des Kühlkörpers, wobei auch die Befestigungsschrauben mechanische Spannungen in das Gesamtsystem einbringen. Die so bewirkten Verformungen der Kontaktflächen bewirken ebenfalls Strömungen, die je nach Stärke und Richtung die Temperaturänderungs-getriebenen Strömungen verstärken können.

Statt des Sandstrahlens ist auch Ätzen verwendbar.

Besonders vorteilhaft ist es, wenn die aufzurauhende Kontaktfläche erhaben ausgeführt ist über einer Oberfläche des Kühlkörpers. Somit muss dann nur dieser Teilbereich eben bearbeitet und danach aufrauhend bearbeitet werden und nicht die gesamte Oberfläche. Die Befestigungsschrauben können beispielsweise auch in den nicht-aufgerauhten Bereich gelegt werden. Die gezeigte Figur 1 gibt nur symbolisch einen wesentlichen Erfindungsgedanken wieder. Insbesondere sind die Abmessungen nicht massstäblich.

Statt der geschilderten Bearbeitungsvorgänge ist auch ein Bearbeiten der Kontaktfläche des Kühlkörpers mittels Erodieren ausführbar, wobei dann die ebene Form und die Rauheit in einem Arbeitsgang herstellbar sind, allerdings kostspieliger.

## Patentansprüche

1. Vorrichtung, umfassend eine elektronische Schaltung mit mindestens einem Halbleitermodul,
wobei das halbleitermodul mit einem Kühlkörper wärmeleitend verbunden ist zur Abführung der Wärme vom Halbleitermodul über den Kühlkörper an ein weiteres Medium oder an eine weitere Vorrichtung,
wobei zwischen den einen Innenbereich und einen Außenbereich umfassenden Kontaktflächen des Halbleitermoduls und des Kühlkörpers Wärmeleitpaste zur Verbesserung der Wärmeleitung eingebracht ist,
wobei die Wärmeleltpaste feste und flüssige Bestandteile umfasst,
**dadurch gekennzeichnet, dass**
mindestens ein Teilbereich der Kontaktfläche des Halbleitermoduls oder der "Kontaktfläche des Kühlkörpers derart aufgeraut ausgeführt ist und die Kontaktflächen möglichst dicht aneinander liegen, damit die festen Bestandteile bei diesen Temperaturänderungen eine Fixierung erfahren, so dass sie nicht oder höchstens stark vermindert zusammen mit den flüssigen Bestandteilen in den Außenbereich auswaschbar sind,
wobei die Rauheit im Teilbereich größer ist als die um 10 µm verminderte Korngröße der festen Bestandteile der Wärmeleitpaste.

2. Vorrichtung nach Anspruch 1,
**dadurch gekennzeichnet, dass**
zur wärmeleitenden Verbindung zwischen Halbleitermodul und Kühlkörper die Kontaktflächen mindestens im Teilbereich eben bearbeitet sind, damit die Kontaktflächen dort dicht aneinander anliegen.

3. Vorrichtung nach einem der vorangegangenen Ansprüche,
**dadurch gekennzeichnet, dass**
der Teilbereich erhaben über der sonstigen Oberfläche ausgeführt ist.

4. Vorrichtung nach einem der vorangegangenen Ansprüche,
**dadurch gekennzeichnet, dass**
die Kontaktflächen zumindest im Teilbereich eine Ebenheit, also Formabweichung oder Gestaltsabweichung erster Ordnung, aufweisen, die besser ist als 5 µm pro 10 mm.

5. Vorrichtung nach einem der vorangegangenen Ansprüche,
**dadurch gekennzeichnet, dass**
die gemittelten Rauhtiefe R_{z} gemäß DIN 4768 einen Wert hat, der größer ist als 20 µm und/oder dass die gemittelten Rauhtiefe R_{z} gemäß DIN 4768 25 µm beträgt.

6. Vorrichtung nach einem der vorangegangenen Ansprüche,
**dadurch gekennzeichnet, dass**
die Aufrauhung innerhalb der Kontaktfläche isotrop ist und/oder keine Vorzugsorientierung besitzt.

7. Vorrichtung nach einem der vorangegangenen Ansprüche,
**dadurch gekennzeichnet, dass**
das Halbleitermodul ein oder mehrere Leistungshalbleiter-Bauelemente umfasst.

8. Vorrichtung nach einem der vorangegangenen Ansprüche,
**dadurch gekennzeichnet, dass**
das Halbleitermodul mit dem Kühlkörper derart wärmeleitend verbunden ist, dass der Wärmeübergangswiderstand zwischen Kühlkörper und Halbleitermodul kleiner ist als der Wärmeübergangswiderstand zwischen Halbleitermodul und weiteren Vorrichtungen oder Medien.

9. Vorrichtung nach einem der vorangegangenen Ansprüche,
**dadurch gekennzeichnet, dass**
das Medium Umgebungsluft, ein metallisches Gehäuse oder eine Flüssigkeit ist.

10. Vorrichtung nach einem der vorangegangenen Ansprüche,
**dadurch gekennzeichnet, dass**
die Vorrichtung ein Umrichter zur elektrischen Versorgung eines oder mehrerer Elektromotoren, insbesondere linearer oder rotatorischer Elektromotoren, ist.

11. Verfahren zur Herstellung einer Vorrichtung nach einem der vorangegangenen Ansprüche,
**dadurch gekennzeichnet, dass**
die Aufrauung derart vorgesehen ist, dass durch vorhergegangene Bearbeitungsschritte entstandene Rauhigkeit mit Ausrichtung, wie beispielsweise Rillen, überdeckt ist.

12. Verfahren nach Anspruch 11,
**dadurch gekennzeichnet, dass**
die Ebenheit, also ebene Form, der Kontaktflächen zumindest im Teilbereich mittels Fräsen, Hohnen, Schleifen und/oder Läppen hergestellt sind.

13. Verfahren nach einem der Ansprüche 11 oder 12,
**dadurch gekennzeichnet, dass**
die Rauheit der Kontaktflächen zumindest im Teilbereich mittels Sandstrahlen, Erodieren oder Ätzen hergestellt sind.

## Claims

1. A device comprising an electronic circuit having at least one semiconductor module, wherein the semiconductor module is connected in a heat-conducting manner to a cooling body for removal of the heat via the cooling body from the semiconductor module to another medium or to another device, wherein heat-conductive paste to improve the heat conduction is introduced between the contact surfaces, comprising an inner region and an outer region, of the semiconductor module and the cooling body, wherein the heat-conductive paste comprises solid and fluid constituents, **characterised in that** at least a partial region of the contact surface of the semiconductor module or of the contact surface of the cooling body is roughened to such an extent that and the contact surfaces lie as close against one another as possible in order that the solid constituents are immobilised during these changes in temperature, so that they cannot be washed out together with the fluid constituents into the outer region or this washing out is as greatly reduced as possible, wherein the roughness in the partial region is greater than the particle size of the solid constituents of the heat-conductive paste reduced by 10 µm.

2. A device according to claim 1, **characterised in that** to connect the semiconductor module and the cooling body in a heat-conductive manner, at least the partial region of the contact surfaces is worked to become plane so that the contact surfaces lie close against one another there.

3. A device according to any one of the preceding claims, **characterised in that** the partial region projects above the rest of the surface.

4. A device according to any one of the preceding claims, **characterised in that** at least the partial region of the contact surfaces has an evenness, therefore form deviation or structural deviation of the first order, better than 5 µm per 10 mm.

5. A device according to any one of the preceding claims, **characterised in that** the averaged depth of roughness R_{z} according to DIN 4768 has a value greater than 20 µm and/or **in that** the averaged depth of roughness R_{z} according to DIN 4768 is 25 µm.

6. A device according to any one of the preceding claims, **characterised in that** the roughening within the contact surface is isotropic and/or does not have a preferred orientation.

7. A device according to any one of the preceding claims, **characterised in that** the semiconductor module comprises one or a plurality of power semiconductor components.

8. A device according to any one of the preceding claims, **characterised in that** the semiconductor module is connected to the cooling body in a heat-conductive manner such that the heat transmission resistance between the cooling body and the semiconductor module is less than the heat transmission resistance between the semiconductor module and further devices or media.

9. A device according to any one of the preceding claims, **characterised in that** the medium is ambient air, a metal housing or a fluid.

10. A device according to any one of the preceding claims, **characterised in that** the device is a converter to supply electricity to one or a plurality of electric motors, in particular linear or rotary electric motors.

11. A method of producing a device according to any one of the preceding claims, **characterised in that** the roughening is provided in such a manner that roughness which has resulted from preceding working steps is covered with an orientation, such as for example channels.

12. A method according to claim 11, **characterised in that** the evenness, therefore plane form, of at least the partial region of the contact surfaces is produced by means of milling, honing, grinding and/or lapping.

13. A method according to any one of claims 11 and 12, **characterised in that** the roughness at least in the partial region of the contact surfaces is produced by means of sand blasting, electrical discharge machining or etching.

## Revendications

1. Dispositif comprenant un circuit électronique et au moins un module à semi-conducteurs,
le module à semi-conducteurs étant relié de manière thermoconductrice à un dissipateur thermique pour dissiper la chaleur du module à semi-conducteurs vers un autre milieu ou un autre dispositif au moyen du dissipateur thermique,
de la pâte thermoconductrice étant appliquée pour améliorer la conduction de chaleur entre les surfaces de contact, comprenant une zone intérieure et une zone extérieure, du module à semi-conducteurs et du dissipateur thermique,
la pâte thermoconductrice comprenant des composants solides et liquides,
**caractérisé en ce**
**qu'**au moins une zone partielle de la surface de contact du module à semi-conducteurs ou de la surface de contact du dissipateur thermique est rugosifiée et que les surfaces de contact sont situées aussi près que possible l'une de l'autre pour que les composants solides subissent une fixation lors de ces variations de température, de sorte qu'ils ne peuvent pas, ou tout au plus de manière fortement réduite, être lessivés dans la zone extérieure en même temps que les composants liquides,
la rugosité dans la zone partielle étant plus grande que la taille de grain réduite de 10 µm des composants solides de la pâte thermoconductrice

2. Dispositif selon la revendication 1,
**caractérisé en ce**
**que** pour la liaison thermoconductrice entre module à semi-conducteurs et dissipateur thermique, les surfaces de contact sont usinées planes au moins dans une zone partielle afin que les surfaces de contact y soient étroitement appliquées l'une contre l'autre.

3. Dispositif selon l'une des revendications précédentes,
**caractérisé en ce**
**que** la zone partielle est réalisée en relief par rapport au reste de la surface.

4. Dispositif selon l'une des revendications précédentes,
**caractérisé en ce**
**que** les surfaces de contact présentent au moins dans la zone partielle une planéité, donc un écart de forme ou un écart de configuration du premier ordre, qui est meilleure que 5 µm par 10 mm.

5. Dispositif selon l'une des revendications précédentes,
**caractérisé en ce**
**que** la profondeur moyenne de rugosité R_{z} selon DIN 4768 a une valeur qui est supérieure à 20 µm et/ou que la profondeur moyenne de rugosité R_{z} selon DIN 4768 a une valeur de 25 µm.

6. Dispositif selon l'une des revendications précédentes,
**caractérisé en ce**
**que** la rugosification à l'intérieur de la surface de contact est isotrope et/ou ne présente pas d'orientation préférentielle.

7. Dispositif selon l'une des revendications précédentes,
**caractérisé en ce**
**que** le module à semi-conducteurs présente un ou plusieurs composants à semi-conducteurs de puissance.

8. Dispositif selon l'une des revendications précédentes,
**caractérisé en ce**
le module à semi-conducteurs est relié au dissipateur thermique d'une manière thermoconductrice telle que la résistance à la transmission de chaleur entre le dissipateur thermique et le module à semi-conducteurs soit plus petite que la résistance à la transmission de chaleur entre le module à semi-conducteurs et d'autres dispositifs ou milieux.

9. Dispositif selon l'une des revendications précédentes,
**caractérisé en ce**
**que** le milieu est l'air ambiant, un boîtier métallique ou un liquide.

10. Dispositif selon l'une des revendications précédentes,
**caractérisé en ce**
**que** le dispositif est un variateur de vitesse utilisé pour l'alimentation électrique d'un ou plusieurs moteurs électriques, en particulier de moteurs électriques linéaires ou rotatifs.

11. Procédé de fabrication d'un dispositif selon l'une des revendications précédentes,
**caractérisé en ce**
**que** la rugosification est prévue de manière qu'une rugosité présentant une orientation, comme par exemple des rainures, résultant d'opérations d'usinage précédentes soit recouverte.

12. Procédé selon la revendication 11,
**caractérisé en ce**
**que** la planéité, donc la forme plane, des surfaces de contact au moins dans la zone partielle est réalisée par fraisage, honage, meulage et/ou rodage.

13. Procédé selon l'une des revendications 11 ou 12,
**caractérisé en ce**
**que** la rugosification des surfaces de contact au moins dans la zone partielle est réalisée par grenaillage, érosion ou décapage.
